# FASCICULE DE BREVET EUROPEEN

(11) **EP 0 817 382 B1**
(45) Date de publication et mention de la délivrance du brevet: **08.01.2003**
(21) Numéro de dépôt: 97401481.3
(22) Date de dépôt: 25.06.1997
(51) Int. Cl.: H03K 17/30, H03K 17/18

(54) **Système de commutation entre des états de veille et de réveil d'une unité de traitement d'informations et d'un commutateur analogique**
System zum Schalten zwischen Wartezustand und Aktivzustand für eine Datenverarbeitungseinheit und einen Analogschalter
System for switching between stand by and wake up for a data processing unit and an analog switch

(30) Priorité: 28.06.1996 FR 9608123
(43) Date de publication de la demande: 07.01.1998
(73) Titulaire: AUTOMOBILES PEUGEOT, 75116 Paris (FR); AUTOMOBILES CITROEN, 92200 Neuilly-sur-Seine (FR)
(72) Inventeur: Loth, Siri Yuth, 95350 Saint Brice Sous Fôret (FR)
(74) Mandataire: Habasque, Etienne Joel Jean-François

(56) Documents cités:
- EP-A- 0 461 432
- US-A- 5 198 697
- "Un amplificateur à deux états de fonctionnement" ELECTRONIQUE, no. 15, 1 février 1992, PARIS, page 23, 25 XP000331790
- SMIT: "Sensing resistor limits power-supply current" ELECTRONICS, vol. 48, no. 25, 11 décembre 1975, NEW YORK US, page 107 XP002027610

## Description

La présente invention concerne un système de commutation entre des états de veille et de réveil, comportant un dispositif de commutation interposé entre une unité de traitement d'informations et au moins un commutateur analogique à niveaux de tension.

On connaît déjà dans l'état de la technique, un certain nombre de systèmes de commutation de ce type, dans lesquels l'unité de traitement d'informations comporte une entrée d'information analogique et une entrée d'information de réveil en provenance d'un commutateur analogique.

Un tel commutateur analogique comporte par exemple un certain nombre de circuits en parallèle, munis chacun d'une résistance de valeur déterminée et d'un interrupteur, et interposés entre l'entrée analogique de l'unité de traitement et la masse,de manière que lorsqu'un utilisateur par exemple actionne l'un des interrupteurs, le commutateur délivre à sa sortie un niveau de tension analogique correspondant à l'état d'actionnement ou non d'un ou de plusieurs interrupteurs. Cette tension analogique est alors transmise à l'unité de traitement d'informations par l'intermédiaire du dispositif de commutation, ce qui permet à cette unité de traiter les informations correspondantes, c'est-à-dire de déterminer par exemple l'état d'actionnement des interrupteurs du commutateur.

Dans l'état de la technique, l'entrée d'information de réveil de l'unité de traitement d'informations est reliée au commutateur et plus particulièrement au point milieu entre une résistance et un interrupteur d'un circuit de celui-ci, à travers une diode et ce commutateur comporte une résistance de détection de défaut connectée entre sa sortie analogique et la masse.

Cette entrée d'information de réveil de l'unité de traitement d'informations est également reliée à une source de tension permanente à travers une résistance, tandis que l'entrée d'information analogique de celle-ci est reliée à une source de tension commandable par cette unité, à travers une résistance et une diode.

En état de veille, l'unité de traitement d'informations coupe la source d'alimentation commandable associée à son entrée d'information analogique et surveille l'état de son entrée d'information de réveil.

En effet, celle-ci est reliée d'une part, à une source de tension permanente et d'autre part, au commutateur.

En état de veille, c'est-à-dire tant qu'aucune action n'est exercée au niveau du commutateur, l'entrée d'information de réveil de l'unité de traitement d'informations est au niveau logique 1.

La source de tension commandable raccordée à l'entrée d'information analogique de l'unité, est alors coupée.

A la suite d'une action au niveau du commutateur, par exemple par fermeture de l'un des interrupteurs de celui-ci, l'entrée d'information de réveil de l'unité de traitement d'informations est mise à la masse grâce à cet actionnement de l'interrupteur, ce qui permet de faire basculer l'entrée d'information de réveil de l'unité de traitement d'informations entre un niveau logique 1 et un niveau logique 0.

L'unité centrale détecte alors ce changement d'état et réveille le dispositif pour le faire passer dans un état de réveil, dans lequel elle déclenche le fonctionnement de la source de tension commandable reliée à son entrée d'information analogique pour permettre la transmission de l'information entre le commutateur et cette entrée d'information analogique de l'unité de traitement d'informations afin que celle-ci soit analysée.

Cependant, on conçoit que cette structure présente un certain nombre d'inconvénients car dans l'état de veille, un courant relativement important circule toujours entre l'unité de traitement d'informations et plus particulièrement la source de tension raccordée à son entrée d'information de réveil et le commutateur du fait de la présence de la résistance de détection de défaut raccordée à la masse.

De plus, cette tension est également appliquée à l'entrée d'information analogique de l'unité de traitement d'informations, ce qui présente un certain nombre de risques de dégradation de celle-ci.

Le but de l'invention est donc de résoudre ces problèmes.

A cet effet, l'invention a pour objet un système de commutation entre des états de veille et de réveil, comportant un dispositif de commutation interposé entre une unité de traitement d'informations et au moins un commutateur analogique à niveaux de tension, dans lequel l'unité de traitement d'informations comporte une entrée d'information analogique et une entrée d'information de réveil, en provenance d'une sortie analogique du commutateur analogique, caractérisé en ce que l'unité de traitement d'informations comporte en outre une sortie de commande d'état de veille/réveil du dispositif, et en ce que ce dispositif comporte un premier organe commutateur à semi-conducteur pilotable à l'ouverture par la sortie de commande d'état de l'unité centrale, interposé entre la sortie analogique du commutateur et un comparateur de tension adapté pour comparer le signal de sortie analogique du commutateur à un niveau de référence, pour délivrer à l'entrée d'information de réveil de l'unité centrale, un ordre correspondant et un second organe commutateur à semi-conducteur pilotable à la fermeture par la sortie de commande d'état de l'unité centrale, interposé entre la sortie analogique du commutateur analogique et l'entrée d'information analogique de l'unité centrale.

Avantageusement, le commutateur analogique comporte une résistance de détection de défaut dont une borne est raccordée à la sortie analogique de ce commutateur analogique et dont une autre borne est adaptée pour être reliée à la masse à travers un troisième organe commutateur à semi-conducteur pilotable à la fermeture par la sortie de commande d'état de l'unité centrale.

L'invention sera mieux comprise à la lecture de la description qui va suivre, donnée uniquement à titre d'exemple et faite en se référant aux dessins annexés, sur lesquels :
- la Fig.1 représente un schéma électrique d'un exemple de réalisation d'un dispositif de commutation de l'état de la technique;
- la Fig.2 représente un schéma synoptique illustrant la structure d'un dispositif de commutation selon l'invention; et
- la Fig.3 représente un schéma électrique d'un tel dispositif de commutation.

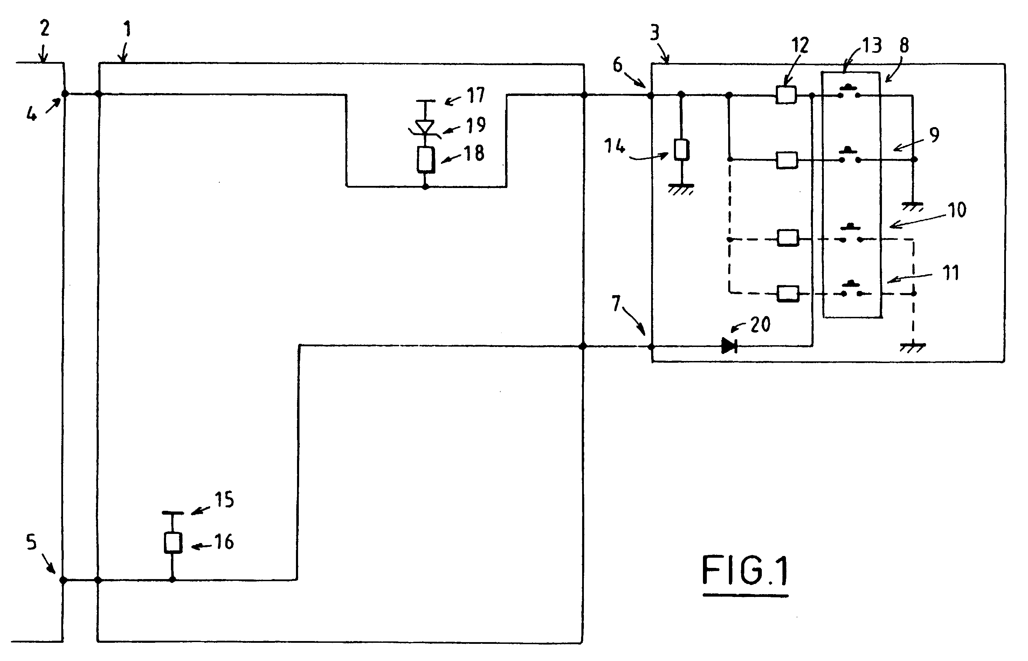

On reconnaît en effet sur la figure 1, un système de commutation qui comporte un dispositif de commutation entre des états de veille et de réveil, désigné par la référence générale 1 sur cette figure, interposé entre une unité de traitement d'informations désignée par la référence générale 2 et au moins un commutateur analogique à niveaux de tension, désigné par la référence générale 3 sur cette figure.

Dans un tel système, l'unité de traitement d'informations 2 comporte une entrée d'information analogique désignée par la référence générale 4 sur cette figure et une entrée d'information de réveil désignée par la référence générale 5, en provenance de bornes correspondantes 6 et 7 du commutateur analogique 3.

Un tel commutateur comporte par exemple plusieurs circuits en parallèle, dont quatre sont désignés par les références générales 8,9,10 et 11 sur cette figure, comportant chacun une résistance en série avec un interrupteur, interposés entre la sortie d'information analogique 6 du commutateur et la masse.

C'est ainsi par exemple que le circuit 8 comporte une résistance 12 en série avec un interrupteur 13 de type bouton-poussoir.

De plus, une résistance de détection de défaut désignée par la référence générale 14, est raccordée entre la sortie d'information analogique 6 de ce commutateur et la masse.

L'entrée d'information de réveil 5 de l'unité de traitement d'informations 2 est également reliée à une source de tension permanente 15 à travers une résistance 16, tandis que l'entrée d'information analogique 4 de celle-ci est reliée à une source de tension 17 commandable par cette unité de traitement d'informations, à travers une résistance 18 et une diode 19.

Une diode 20 est disposée dans le circuit de l'entrée d'information de réveil de l'unité 2.

Comme on l'a indiqué précédemment, dans l'état de veille, l'unité de traitement d'informations 2 coupe la source de tension commandable 17.

Par ailleurs, cette unité de traitement d'informations surveille le niveau logique de son entrée d'information de réveil 5 qui passe d'un état logique 1 à un état logique 0, en cas d'actionnement par exemple de l'un des interrupteurs du commutateur.

Dans ce cas, l'unité centrale 2 déclenche le fonctionnement de la source de tension commandable 17 pour permettre la transmission de l'information analogique du commutateur 3 vers l'entrée d'information analogique 4 de cette unité 2 afin de permettre une analyse de cette information.

Comme on l'a indiqué précédemment, cette structure présente un certain nombre d'inconvénients et notamment de réveil à faible courant, d'obligation d'intégrer dans le commutateur des composants passifs tels que des résistances et des composants actifs tels que des diodes, comme la diode 20 interposée dans le circuit de l'entrée d'information de réveil de l'unité, de consommation relativement importante dans l'état de veille et d'injection d'un niveau de tension permanente dans l'entrée d'information analogique de l'unité centrale.

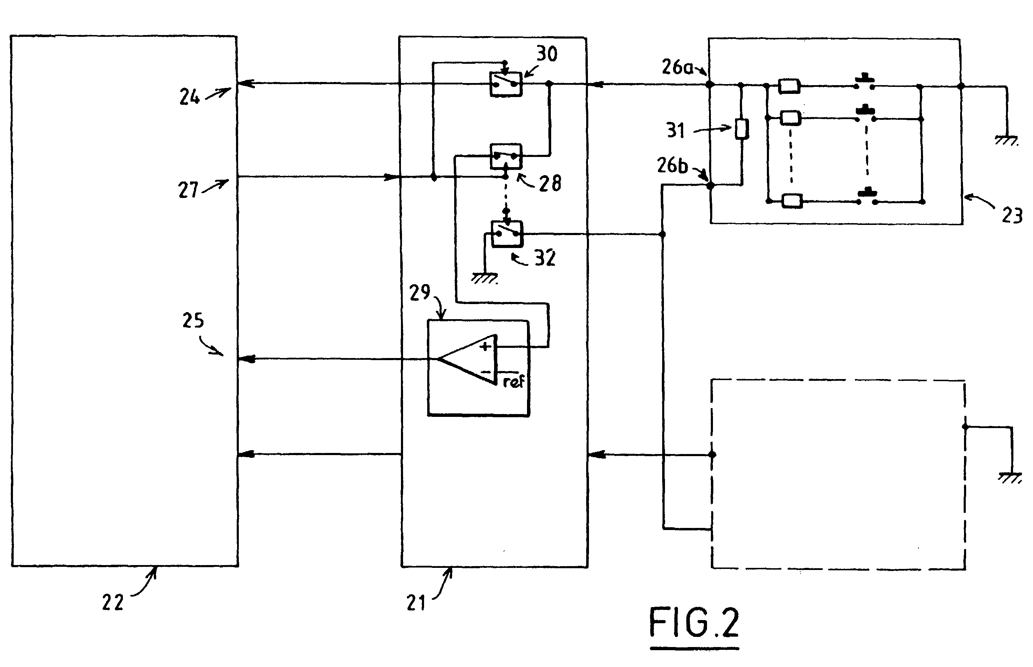

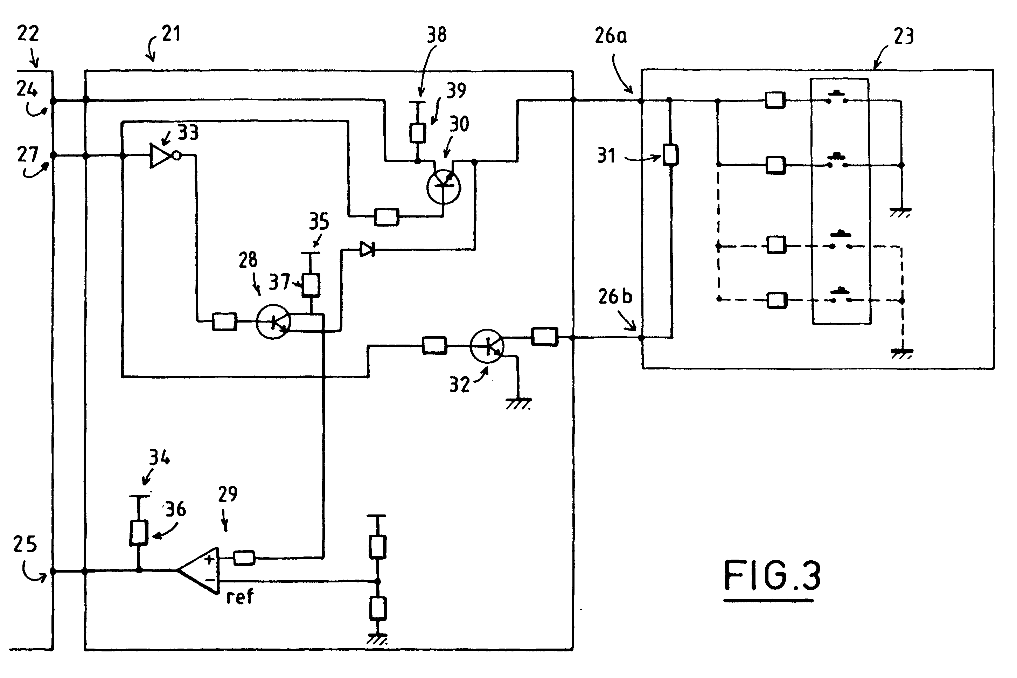

On a représenté sur les figures 2 et 3, un système de commutation selon l'invention.

On reconnaît sur ces figures, un dispositif de commutation qui est désigné par la référence générale 21 sur ces figures et qui est interposé entre une unité centrale de traitement d'informations 22 et au moins un commutateur 23, ce commutateur étant un commutateur analogique à niveaux de tension analogue à celui décrit précédemment.

L'unité de traitement d'informations comporte toujours une entrée d'information analogique désignée par la référence générale 24 et une entrée d'information de réveil, désignée par la référence générale 25 sur cette figure, ces entrées pouvant être raccordées à des bornes correspondantes 26a et 26b du commutateur 23.

Le commutateur analogique 23 comporte toujours par exemple plusieurs circuits en parallèle, munis chacun d'une résistance et d'un interrupteur ou d'un bouton-poussoir, interposés entre la sortie d'information analogique 26a du commutateur et la masse, de sorte que l'on ne le décrira pas plus en détail par la suite.

Selon l'invention, l'unité de traitement d'informations 22 comporte également une sortie de commande d'état de veille/réveil du dispositif, désignée par la référence générale 27 sur ces figures.

De plus, le dispositif de commutation 21 comporte un premier organe commutateur à semi-conducteur pilotable à l'ouverture par la sortie de commande d'état 27 de l'unité centrale, désigné par la référence générale 28 sur ces figures, et interposé entre la sortie analogique 26a du commutateur et un comparateur de tension 29, adapté pour comparer le signal de sortie analogique du commutateur à un niveau de référence ref, pour délivrer à l'entrée d'information de réveil 25 de l'unité centrale, un ordre correspondant.

De plus, le dispositif de commutation 21 comporte un second organe commutateur à semi-conducteur pilotable à la fermeture par la sortie de commande d'état de l'unité centrale désignée par la référence générale 27, cet organe commutateur à semi-conducteur étant désigné par la référence générale 30 sur ces figures et étant interposé entre la sortie analogique 26a du commutateur analogique 23 et l'entrée d'information analogique 24 de l'unité centrale 22.

Le commutateur 23 comporte également une résistance 31 de détection de défaut dont une borne est reliée à la sortie analogique 26a de ce commutateur et dont l'autre borne est adaptée pour être reliée à la masse à travers un troisième organe commutateur à semi-conducteur, pilotable à la fermeture par la sortie de commande d'état 27 de l'unité centrale et désigné par la référence générale 32 sur ces figures.

Comme on peut le voir sur la figure 3, ces différents organes commutateurs à semi-conducteur peuvent comporter des transistors par exemple NPN, le transistor constituant l'organe commutateur à semi-conducteur 28 pilotable à l'ouverture étant associé à un inverseur désigné par la référence générale 33 sur cette figure 3, interposé entre la base de celui-ci et la sortie de commande d'état 27 de l'unité centrale.

Enfin, l'entrée d'information de réveil 25 et la sortie de commande d'état 27 de l'unité sont reliées à des sources de tension permanentes 34 et 35 respectivement à travers des résistances 36 et 37, tandis que l'entrée d'information analogique 24 de celle-ci est reliée à une source de tension commandable 38 à travers une résistance 39, de façon classique.

On conçoit que le fonctionnement d'un tel système est le suivant.

En état de veille, l'unité de traitement coupe la source de tension 38 et le dispositif de commutation 21 déconnecte le ou chaque commutateur de l'entrée d'information analogique correspondante 24 de l'unité centrale 22.

A cet effet, cette unité centrale 22 délivre à sa sortie de commande d'état de veille/réveil 27, un niveau logique 0 de pilotage des organes commutateurs à semi-conducteur 28,30 et 32.

Dans ce cas, les organes 30 et 32 sont ouverts, tandis que l'organe commutateur à semi-conducteur 28 est fermé du fait de l'interposition de l'inverseur 33 entre cette sortie de l'unité et le transistor correspondant.

Ainsi, l'information de sortie analogique provenant du commutateur 23 est déconnectée de l'unité centrale par l'organe commutateur à semi-conducteur 30, tandis que la résistance 31 de détection de défaut n'est pas reliée à la masse du fait de l'ouverture de l'organe commutateur à semi-conducteur 32.

L'information analogique de sortie du commutateur 23 est alors dirigée vers l'une des bornes et par exemple la borne non-inverseuse du comparateur 29 par l'organe commutateur à semi-conducteur 28 qui est fermé.

Le niveau de référence ref de l'entrée inverseuse de ce comparateur 29 peut être fixé de telle sorte qu'il soit inférieur au niveau d'entrée sur l'autre borne de celui-ci si aucun des interrupteurs par exemple du commutateur n'est activé.

Dans ce cas, la sortie de ce comparateur 29 reste à l'état logique 1, en veille.

Dès qu'une action est exercée au niveau du commutateur 23 et que par exemple l'un des boutons-poussoirs ou interrupteurs de celui-ci est actionné, le comparateur 29 voit le niveau de son entrée non-inverseuse devenir inférieur à celui de son entrée inverseuse, de sorte qu'il bascule sa sortie à l'état logique 0.

Ceci provient du fait que par exemple les interrupteurs de ce commutateur sont reliés à la masse.

Ce changement d'état de la sortie du comparateur 29 et donc de l'entrée d'information de réveil 25 de l'unité centrale 22, est détecté par celle-ci qui réveille le dispositif en déclenchant le fonctionnement de la source 38 et en basculant sa sortie de commande d'état de veille/réveil 27.

Un ordre de réveil est donc envoyé par cette sortie de l'unité centrale au dispositif.

Cet ordre est reçu par le dispositif pour basculer les différents organes commutateurs à semi-conducteur de celui-ci, c'est-à-dire pour ouvrir l'organe commutateur 28 et fermer les organes commutateurs 30 et 32.

Ainsi, l'information analogique provenant du commutateur 23, peut circuler à travers l'organe commutateur à semi-conducteur 30 en direction de l'entrée d'information analogique 24 de l'unité centrale 22, tandis que l'organe commutateur à semi-conducteur 32 connecte la borne correspondante de la résistance 31 de détection de défaut à la masse, ce qui permet de détecter des défauts par exemple de commutateur débranché ou court-circuité.

Les transistors sont bien entendu associés à des résistances de polarisation de façon classique et le signal de référence appliqué au comparateur peut être obtenu par exemple à l'aide d'un pont de résistances.

On conçoit alors qu'un tel dispositif permet de réduire au minimum la consommation de courant en état de veille, en déconnectant complètement le ou les commutateurs analogiques de l'unité centrale, mais en veillant à l'informer de toutes les demandes de réveil par l'un de ceux-ci.

On notera que les résistances des circuits en parallèle du commutateur sont par exemple différentes pour permettre la reconnaissance de l'information analogique, de façon classique.

Le dispositif selon l'invention présente donc un certain nombre d'avantages par rapport aux dispositifs de l'état de la technique, notamment au niveau de sa modularité, de sa consommation négligeable en état de veille, cette consommation étant indépendante du nombre de commutateurs ajoutés, de la possibilité d'utiliser plusieurs interrupteurs ou équivalents dans un commutateur sans ajouter de composants supplémentaires dans le dispositif de commutation, de n'utiliser que des composants passifs dans le commutateur, de permettre un réveil avec un courant beaucoup plus important que dans l'état de la technique, de sélectionner un ou plusieurs interrupteurs par exemple des commutateurs, qui permettront le réveil du système en agissant sur le seuil de référence appliqué à l'entrée inverseuse du comparateur 29 et enfin de ne nécessiter aucune modification du nombre de fils branchés entre l'unité centrale et le ou chaque commutateur.

## Revendications

1. Système de commutation entre des états de veille et de réveil, comportant un dispositif de commutation (21) interposé entre une unité de traitement d'information (22) et au moins un commutateur analogique à niveaux de tension (23), dans lequel l'unité de traitement d'information (22) comporte une entrée d'information analogique (24) et une entrée d'information de réveil (25) en provenance d'une sortie analogique du commutateur analogique, **caractérisé en ce que** l'unité de traitement d'informations (22) comporte en outre une sortie (27) de commande d'état de veille/réveil du dispositif, et **en ce que** ce dispositif de commutation comporte un premier organe commutateur à semi-conducteur (28) pilotable à l'ouverture par la sortie de commande d'état de veille/réveil de l'unité de traitement d'information, interposé entre la sortie analogique du commutateur et un comparateur (29) de tension adapté pour comparer le signal de sortie analogique du commutateur à un niveau de référence pour délivrer à l'entrée d'information de réveil (25) de l'unité de traitement d'information un ordre correspondant, et un second organe commutateur à semi-conducteur (30) pilotable à la fermeture par la sortie de commande d'état de veille/réveil de l'unité de traitement d'information, interposé entre la sortie analogique du commutateur analogique et l'entrée d'information analogique (24) de l'unité de traitement d'information.

2. Système selon la revendication 1, **caractérisé en ce que** le commutateur analogique (23) comporte une résistance de détection de défaut (31) dont une borne est raccordée à la sortie analogique de ce commutateur et dont une autre borne est adaptée pour être reliée à la masse à travers un troisième organe commutateur à semi-conducteur (32) du dispositif, de commutation, pilotable à la fermeture par la sortie de commande d'état de veille/réveil (27) de l'unité de traitement d'information (22).

3. Système selon la revendication 1 ou 2, **caractérisé en ce que** les organes commutateurs à semi-conducteur comprennent des transistors.

4. Système selon la revendication 3, **caractérisé en ce que** le transistor constituant l'organe commutateur à semi-conducteur (28) pilotable à l'ouverture est associé à un inverseur (33) interposé entre la base de celui-ci et la sortie de commande d'état de veille/réveil (27) de l'unité de traitement d'information.

## Patentansprüche

1. System zum Schalten zwischen einem Wartezustand und einem Weckzustand, umfassend eine Schaltvorrichtung (21), die zwischen eine Informationsverarbeitungseinheit (22) und mindestens einen analogen Schalter mit Spannungspegeln (23) eingesetzt ist, bei dem die Informationsverarbeitungseinheit (22) einen analogen Informationseingang (24) und einen Eingang (25) für die von einem analogen Ausgang des analogen Schalters kommende Weckinformation aufweist, **dadurch gekennzeichnet, daß** die Informationsverarbeitungseinheit (22) außerdem einen Ausgang (27) zur Steuerung des Warte/Weck-Zustands der Vorrichtung aufweist und daß diese Schaltvorrichtung ein erstes Halbleiter-Schaltorgan (28) aufweist, das durch den Ausgang zur Steuerung des Warte/Weck-Zustands der Informationsverarbeitungseinheit bei der Öffnung steuerbar ist und das zwischen den analogen Ausgang des Schalters und einen Spannungsvergleicher (29) eingesetzt ist, der dafür ausgelegt ist, das analoge Ausgangssignal mit einem Bezugspegel zu vergleichen, um am Weckinformationseingang (25) der Informationsverarbeitungseinheit einen entsprechenden Befehl zu liefern, sowie ein zweites Halbleiter-Schaltorgan (30), das durch den Ausgang zur Steuerung des Warte/Weck-Zustands der Informationsverarbeitungseinheit bei der Schließung steuerbar ist und das zwischen den analogen Ausgang des analogen Schalters und den analogen Informationseingang (24) der Informationsverarbeitungseinheit eingesetzt ist.

2. System nach Anspruch 1, **dadurch gekennzeichnet, daß** der analoge Schalter (23) einen Fehlererfassungswiderstand (31) aufweist, von dem ein Anschluß mit dem analogen Ausgang dieses Schalters verbunden ist und der andere Anschluß dafür ausgelegt ist, mit der Masse über ein drittes Halbleiter-Schaltorgan (32) der Schaltvorrichtung verbunden zu werden, das durch den Ausgang zur Steuerung des Warte/Weck-Zustands (27) der Informationsverarbeitungseinheit (22) bei der Schließung steuerbar ist.

3. System nach Anspruch 1 oder 2, **dadurch gekennzeichnet, daß** die Halbleiter-Schaltorgane Transistoren aufweisen.

4. System nach Anspruch 3, **dadurch gekennzeichnet, daß** der Transistor, der das bei der Öffnung steuerbare Halbleiter-Schaltorgan (28) bildet, einem Umkehrorgan (33) zugeordnet ist, das zwischen dessen Basis und dem Ausgang zur Steuerung des Warte/Weck-Zustands (27) der Informationsverarbeitungseinheit angeordnet ist.

## Claims

1. System for switching between standby and active states, comprising a switching device (21) interposed between a data processing unit (22) and at least one analogue switch with voltage levels (23), wherein the data processing unit (22) comprises an analogue data input (24) and an input (25) for activating data from an analogue output of the analogue switch, **characterised in that** the data processing unit (22) further comprises an output (27) for controlling the standby/active state of the device, and **in that** this switching device comprises a first semi-conductor switching member (28) which can be made to open by the output for controlling the standby/active state of the data processing unit, interposed between the analogue output of the switch and a voltage comparator (29) adapted to compare the analogue output signal of the switch with a reference level in order to deliver a corresponding order to the activating data input (25) of the data processing unit, and a second semi-conductor switching member (30) which can be made to close by the output of the data processing unit which controls the standby/active state, interposed between the analogue output of the analogue switch and the analogue data input (24) of the data processing unit.

2. System according to claim 1, **characterised in that** the analogue switch (23) comprises a fault detection resistor (31) one terminal of which is connected to the analogue output of this switch while another terminal is adapted to be connected to earth through a third semi-conductor switching member (32) of the switching device, which can be operated to close by the output (27) of the data processing unit (22) which controls the standby/active state.

3. System according to claim 1 or 2, **characterised in that** the semi-conductor switching members comprise transistors.

4. System according to claim 3, **characterised in that** the transistor which constitutes the semi-conductor switching member (28) that can be made to open, is associated with an inverter (33) interposed between the base thereof and the output (27) of the data processing unit which controls the standby/active state.
